# EUROPEAN PATENT APPLICATION

(11) **EP 4 790 869 A1**
(43) Date of publication of application: **12.08.2026**
(21) Application number: 26156552.7
(22) Date of filing: 05.02.2026
(51) Int. Cl.: H02J 7/90, H01M 10/48, H02J 9/06

(54) **ESTIMATING TEMPERATURE OR CHARGE STATE OF EXTERNAL BATTERY OF POWER SUPPLY**

(30) Priority: 05.02.2025 US 202519046063
(71) Applicant: Appleton Grp LLC, Rosemont, IL 60018 (US)
(72) Inventor: PLACIDO, Leon Dela Cruz, San Roque Antipolo City, Rizal 1870 (PH); DE CASTRO, Roderick Perez, Batangas 4209 (PH); CALUBAQUIB, Ralph, Rosemont, IL 60018 (US); YUMOL, Stephen Karl, Pasig 1600 (PH)
(74) Representative: Kehl, Ascherl, Liebhoff & Ettmayr Patentanwälte Partnerschaft mbB

(57) **Abstract**

A method is provided and includes receiving temperatures of a main body of a power supply and generating, using a model, a temperature of an external battery of the power supply. A second method includes accessing data sets that each include a first voltage across an external first battery of a first power supply, a first current flowing through the first battery, a first charge state of the first battery, and a first temperature of the first battery. The second method includes using the data sets to train a model to receive a second voltage across a second battery of a second power supply, a second current flowing through the second battery, and a second temperature of the second battery, and generate a second charge state of the second battery based on the second voltage, the second current, and the second temperature.

## Description

### FIELD

The present disclosure relates generally to using a computational model to estimate a temperature or a charge state of an external battery of a power supply, and more specifically to estimating the temperature or the charge state of the external battery based on one or more temperatures of a main body of the power supply, a voltage across the battery, and/or a current flowing through the battery.

### BACKGROUND

Some power supplies are configured to operate in a normal mode and a battery backup mode. In the normal mode, the power supply receives input electrical power, regulates or conditions the input electrical power, and provides that power to a load. The battery backup mode can be triggered when the input electrical power is offline. An external battery is connected to the power supply via a power cable. In the battery backup mode, the power supply receives electrical power from the battery, regulates or conditions that power, and provides that power to the load.

It can be beneficial to reliably estimate a charge state of the battery so that readiness to operate in the battery backup mode or the general condition of the battery can be assessed. During operation of the power supply, however, it is often impractical to perform direct measurements of the battery that can yield an accurate charge state of the battery.

### SUMMARY

A first example is a method including accessing first data sets that each include one or more first temperatures of a first main body of a first power supply and a second temperature of a first battery of the first power supply. The first battery is external to the first main body. The method also includes using the first data sets to train a first computational model to perform functions. The functions include receiving one or more third temperatures of a second main body of a second power supply, and generating a fourth temperature of a second battery of the second power supply based on the one or more third temperatures. The second battery is external to the second main body.

A second example is a non-transitory computer readable medium storing instructions that, when executed by a computing device, cause the computing device to perform the method of the first example.

A third example is a computing device including: one or more processors; and a computer readable medium storing instructions that, when executed by the one or more processors, cause the computing device to perform the method of the first example.

A fourth example is a method including: accessing data sets that each include a first voltage across a first battery of a first power supply, a first current flowing through the first battery, a first charge state of the first battery, and a first temperature of the first battery. The first battery is external to a first main body of the first power supply. The method also includes using the data sets to train a computational model to perform functions. The functions include receiving a second voltage across a second battery of a second power supply, a second current flowing through the second battery, and a second temperature of the second battery, and generating a second charge state of the second battery based on the second voltage, the second current, and the second temperature.

A fifth example is a non-transitory computer readable medium storing instructions that, when executed by a computing device, cause the computing device to perform the method of the fourth example.

A sixth example is a computing device including: one or more processors; and a computer readable medium storing instructions that, when executed by the one or more processors, cause the computing device to perform the method of the fourth example.

A seventh example is a method including: receiving one or more first temperatures of a main body of a power supply, and generating, using a first computational model, a second temperature of a battery of the power supply using the one or more first temperatures. The battery is external to the main body.

An eighth example is a non-transitory computer readable medium storing instructions that, when executed by a computing device, cause the computing device to perform the method of the seventh example.

A ninth example is a computing device including: one or more processors; and a computer readable medium storing instructions that, when executed by the one or more processors, cause the computing device to perform the method of the seventh example.

By the term "about" or "substantially" with reference to amounts or measurement values described herein, it is meant that the recited characteristic, parameter, or value need not be achieved exactly, but that deviations or variations, including for example, tolerances, measurement error, measurement accuracy limitations and other factors known to those of skill in the art, may occur in amounts that do not preclude the effect the characteristic was intended to provide.

The features, functions, and advantages that have been discussed can be achieved independently in various examples or may be combined in yet other examples further details of which can be seen with reference to the following description and drawings.

### BRIEF DESCRIPTION OF THE DRAWINGS

The novel features believed characteristic of the illustrative examples are set forth in the appended claims. The illustrative examples, however, as well as a preferred mode of use, further objectives and descriptions thereof, will best be understood by reference to the following detailed description of an illustrative example of the present disclosure when read in conjunction with the accompanying Figures.
Figure 1 is a block diagram of a computing device, a power supply, and a battery, according to an example.
Figure 2 is a block diagram of a computing device, a power supply, and a battery, according to an example.
Figure 3 shows training data sets including temperature, voltage, current, and charge state data, according to an example.
Figure 4 is a block diagram of a method, according to an example.
Figure 5 is a block diagram of a method, according to an example.
Figure 6 is a block diagram of a method, according to an example.
Figure 7A shows a correlation between temperatures detected within a housing of a power supply and temperatures detected at an external battery of the power supply, according to an example.
Figure 7B shows a correlation between temperatures detected at a normal mode bypass circuit of a power supply and temperatures detected at an external battery of the power supply, according to an example.
Figure 7C shows a correlation between temperatures detected at a battery mode bypass circuit of a power supply and temperatures detected at an external battery of the power supply, according to an example.
Figure 7D shows a correlation between temperatures detected at a battery charger circuit of a power supply and temperatures detected at an external battery of the power supply, according to an example.
Figure 8A shows correlations between temperatures detected at various locations within a main body of a power supply and temperatures detected at an external battery of the power supply, according to an example.
Figure 8B shows correlations between temperatures detected at various locations within a main body of a power supply and temperatures detected at an external battery of the power supply, according to an example.
Figure 9A shows correlations between battery voltages and states of charge of a battery, according to an example.
Figure 9B shows correlations between battery currents and states of charge of a battery, according to an example.
Figure 9C shows correlations between battery temperatures and states of charge of a battery, according to an example.
Figure 10A shows correlations between battery voltages, currents, and temperatures, and states of charge of a battery, according to an example.
Figure 10B shows correlations between battery voltages, currents, and temperatures, and states of charge of a battery, according to an example.

### DETAILED DESCRIPTION

The present disclosure provides for accurate estimation of a temperature or a charge state of an external battery of a power supply, using information that is readily available during operation of the power supply, and includes a method of training a first computational model to infer a temperature of an external battery of a power supply based on one or more temperatures of a main body *(e.g.,* a housing) of the power supply. The method includes accessing first data sets that each include one or more first temperatures of a first main body of a first power supply and a second temperature of a first battery of the first power supply. Generally, many experiments are conducted in which the actual temperature of a battery is monitored over time while one or more temperatures of the corresponding main body are also monitored. For example, a first temperature sensor, placed in direct contact with an interior or exterior surface of the external battery's housing could be used to detect temperatures of the battery over time, and one or more second temperature sensors could be mounted to various locations inside or outside the main body of the power supply. These data sets can be used to recognize statistical correlations between the temperatures detected at the main body and the temperatures detected at the battery. The method also includes using the first data sets to train a first computational model to perform functions at runtime. The functions include receiving one or more third temperatures of a second main body of a second power supply (e.g. during runtime operation of the second power supply) and generating *(e.g.,* inferring) a fourth temperature of a second *(e.g.,* external) battery of the second power supply based on the one or more third temperatures. At runtime, the inferred temperature of the battery in operation can be used to further infer a charge state of the battery, as described below.

A computing device can be further trained to infer a charge state of the battery based at least in part on the inferred temperature of the battery. The charge state can be a ratio of the charge currently stored by the battery to the battery's nominal or actual full storage capacity. For example, a method includes accessing data sets that each include a first voltage across a first (e.g., external) battery of a first power supply, a first current flowing through the first battery, a first charge state of the first battery, and a first temperature of the first battery. Generally, many experiments are conducted in which the actual output voltage, output current, charge state, and temperature of a battery is monitored over time during various operating conditions such as charging or providing power to a load. These data sets can be used to recognize statistical correlations between the charge state of the battery and the voltage, current, and temperature of the battery. The method also includes using the data sets to train a computational model to perform functions. The functions include receiving, during runtime operation of a second power supply, a second voltage across a second external battery of the second power supply, a second current flowing through the second battery, and a second temperature of the second battery, and generating a charge state of the second battery based on the second voltage, the second current, and the second temperature. The aforementioned methods facilitate estimation of battery temperature and charge state of a battery using data that is more readily available during runtime operation of the power supply.

Disclosed examples will now be described more fully hereinafter with reference to the accompanying Drawings, in which some, but not all of the disclosed examples are shown. Indeed, several different examples may be described and should not be construed as limited to the examples set forth herein. Rather, these examples are described so that this disclosure will be thorough and complete and will fully convey the scope of the disclosure to those skilled in the art.

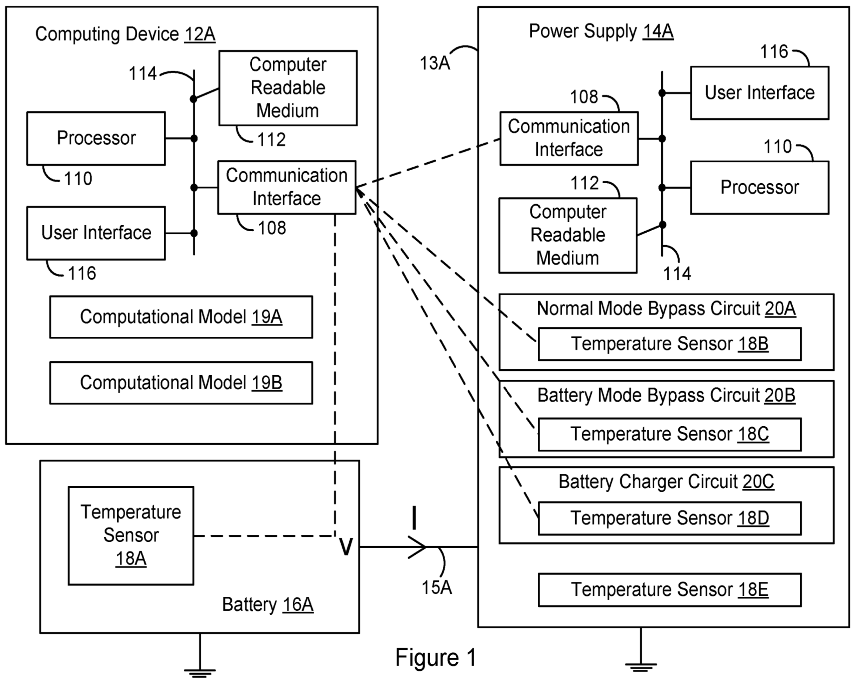

Figure 1 is a block diagram of a computing device 12A, a power supply 14A, and a battery 16A with which aspects of the present disclosure can be implemented. The computing device 12A and the power supply 14A each include a communication interface 108, one or more processors 110, a computer readable medium 112, and a user interface 116. The user interface 116, the communication interface 108, the processor 110, and the computer readable medium 112 can be linked with each other via a system bus, network, or other connection mechanism 114.

The communication interface 108 may take a variety of forms and is configured to allow the computing device 12A and the power supply 14A to communicate with one or more other devices according to any number of protocols. In some examples, the communication interface 108 may take the form of a wired interface, such as an Ethernet interface. Additionally or alternatively, the communication interface 108 may take the form of a wireless interface, such as a cellular interface, a Bluetooth interface, or a Wi-Fi interface.

The processor 110 may include a general purpose processor (e.g., a microprocessor or a microcontroller) and/or a special purpose processor (e.g., a digital signal processor (DSP)).

The computer readable medium 112 may include one or more volatile, non-volatile, removable, and/or non-removable storage components, such as magnetic, optical, or flash storage, and may be integrated in whole or in part with the processor 110. Further, the computer readable medium 112 may have stored thereon program instructions (e.g., compiled or non-compiled program logic and/or machine code) that, when executed by the processor 110, cause the computing device 12A or the power supply 14A to perform one or more functions, such as those described in this disclosure. In some examples, the computer readable medium 112 includes an electrically erasable programmable read-only memory (EEPROM), a non-volatile memory, and a random access memory (RAM).

In some examples, the computer readable medium 112 stores instructions representing a computational model 19A and a computational model 19B. The computational model 19A and the computational model 19B can take the form of an artificial neural network, a machine learning algorithm, and/or a polynomial regression algorithm, for example.

The user interface 116 is configured for facilitating interaction between the computing device 12A or the power supply 14A and a user, such as by receiving input from the user and providing output to the user. Thus, the user interface 116 may include input components such as a keyboard, a touchscreen, or push buttons. In addition, the user interface 116 may include output components such as a display screen, a sound speaker, or other audio output mechanism.

The computing device 12A can take the form of a desktop computer, a tablet computer, a smartphone, or a server. Other examples are possible.

The power supply 14A can take the form of an industrial power supply or a UPS system. For instance, the power supply 14A can take the form of a SolaHD SDN10 24 100D, SDN20 24 100D, or SDN40 24 100D power supply or a SolaHD uninterruptible power supply system SDU10 24B or SDU20 24B.

The power supply 14A includes a normal mode bypass circuit 20A, a battery mode bypass circuit 20B, and a battery charger circuit 20C. The normal mode bypass circuit 20A is configured to receive a main power input (e.g., from a utility company or power plant) and generate or provide a regulated and/or conditioned power output for a load. The battery mode bypass circuit 20B is configured to receive an auxiliary power input from the battery 16A *(e.g.,* via the power cable 15A) and generate a regulated and/or conditioned power output for the load. The battery charger circuit 20C is configured to receive the main power input and charge the battery 16A via the power cable 15A.

A temperature sensor 18B is positioned adjacent to or mounted to the normal mode bypass circuit 20A. A temperature sensor 18C is positioned adjacent to or mounted to the battery mode bypass circuit 20B. A temperature sensor 18D is positioned adjacent to or mounted to the battery charger circuit 20C. The temperature sensor 18B could be mounted near the normal mode bypass circuit 20A on an interior surface of the housing of the main body 13A. The temperature sensor 18C could be mounted near the battery mode bypass circuit 20B on an interior surface of the housing of the main body 13A. The temperature sensor 18D could be mounted near the battery charger circuit 20C on an interior surface of the housing of the main body 13A. Other examples are possible.

The battery 16A generally takes the form of one or more electrochemical cells that store electric charge. The battery 16A is connected to the power supply 14A via the power cable 15A. The battery 16A is generally mounted on the exterior of the power supply 14A or at some other standardized location a short distance away from the power supply 14A. A temperature sensor 18A is positioned adjacent to or mounted to the battery 16A.

The components shown in Figure 1 can be used to train the computational model 19A to infer a temperature of the battery 16A based on one or more temperatures detected at the main body 13A *(e.g.,* a housing or a control module) of the power supply 14A. The components shown in Figure 1 can also be used to train the computational model 19B to infer a charge state of the battery 16A based on the voltage of the battery 16A, the current of the battery 16A, and the temperature of the battery 16A.

In this disclosure, the computational model 19A and the computational model 19B are generally described as being stored on the computing device 12A, but the computational model 19A and the computational model 19B could also be stored and executed on the power supply 14A. Thus, actions described as being performed by the computing device 12A can also generally be performed by the power supply 14A. Other examples are possible.

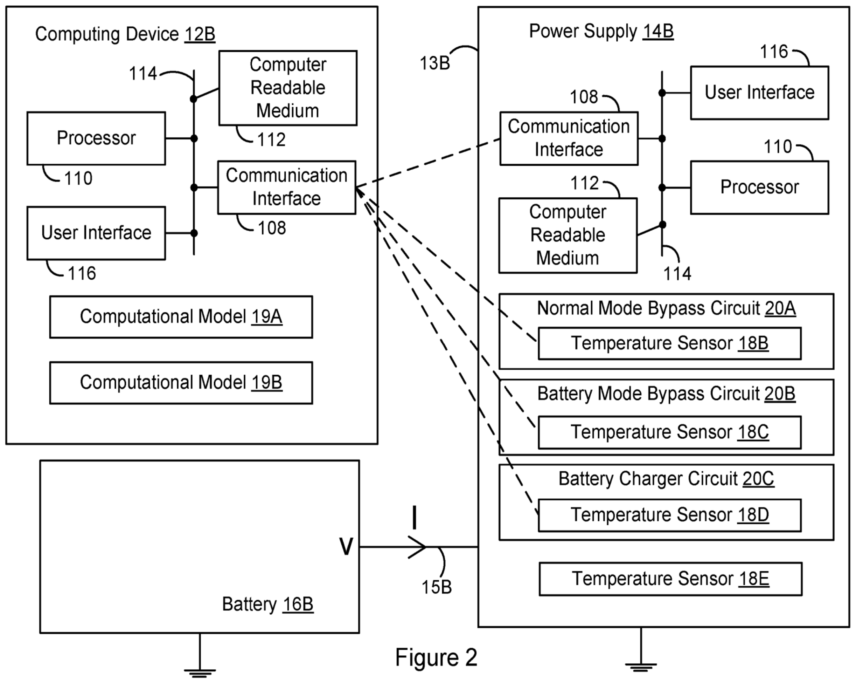

Figure 2 is a block diagram of a computing device 12B, a power supply 14B, and a battery 16B with which aspects of the present disclosure can be implemented. The computing device 12B, the power supply 14B, and the battery 16B generally have all of the structures and functionality of the computing device 12A, the power supply 14A, and the battery 16A described above. The battery 16B is connected to the power supply 14B via the power cable 15B.

The components shown in Figure 2 can be used in conjunction with the computational model 19A to infer a temperature of the battery 16B based on one or more temperatures detected at the main body 13B of the power supply 14B. The components shown in Figure 2 can also be used in conjunction with the computational model 19B to infer a charge state of the battery 16B based on the voltage of the battery 16B, the current of the battery 16B, and the temperature of the battery 16B.

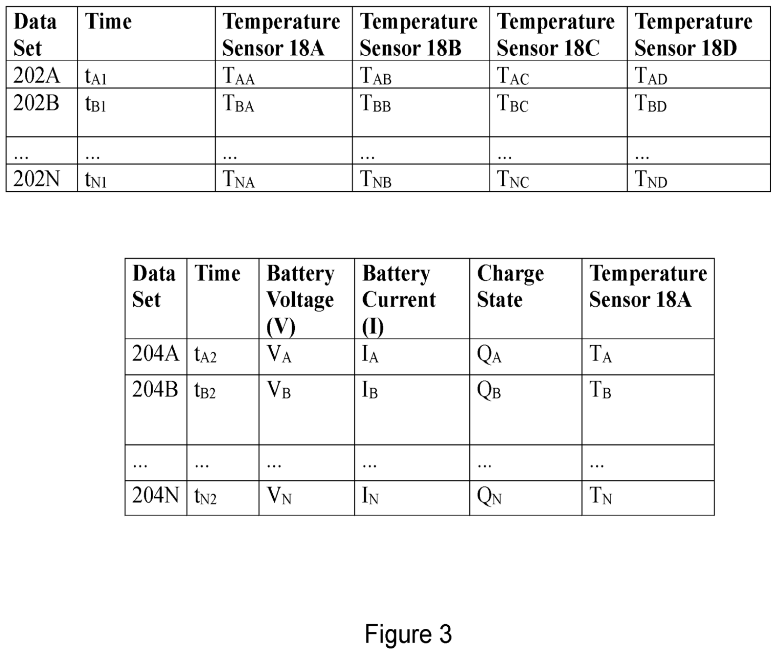

Figure 3 shows a data set 202A, a data set 202B, a data set 202N, a data set 204A, a data set 204B, and a data set 204N. Although only six data sets are shown, generally N for the group of data sets 202A-N and the group of data sets 204A-N can be greater than 100, greater than 1000, or even more numerous, and thus many more data sets can be collected for training the computational model 19A and the computational model 19B.

The data set 202A includes temperature data collected at a time t_{A1}, the data set 202B includes temperature data collected at a time t_{B1}, and the data set 202N includes temperature data collected at a time t_{N1}, and so on. The data set 202A includes a temperature T_{AA} detected by the temperature sensor 18A, a temperature T_{AB} detected by the temperature sensor 18B, a temperature T_{AC} detected by the temperature sensor 18C, and a temperature T_{AD} detected by the temperature sensor 18D. The data set 202B includes a temperature T_{BA} detected by the temperature sensor 18A, a temperature T_{BB} detected by the temperature sensor 18B, a temperature T_{BC} detected by the temperature sensor 18C, and a temperature T_{BD} detected by the temperature sensor 18D. The data set 202N includes a temperature T_{NA} detected by the temperature sensor 18A, a temperature T_{NB} detected by the temperature sensor 18B, a temperature T_{NC} detected by the temperature sensor 18C, and a temperature T_{ND} detected by the temperature sensor 18D. The data sets 202A-N generally include data collected during various operational states of the power supply 14A, such as the power supply 14A operating with the normal mode bypass circuit 20A enabled, the power supply 14A operating with the battery mode bypass circuit 20B enabled, or the power supply 14A operating with the battery charger circuit 20C enabled.

To train the computational model 19A, the computing device 12A accesses the data sets 202A-N. As noted above, in some examples, the data sets 202A-N can include thousands of sets of temperature data collected by the temperature sensors 18A-D during experiments. The temperatures could be numerical values in Celsius or Fahrenheit units, for example. Generally, the data set 202A indicates that the temperature T_{AA}, the temperature T_{AB}, the temperature T_{AC}, and the temperature T_{AD} were all detected at the time t_{A1}, the data set 202B indicates that the temperature T_{BA}, the temperature T_{BB}, the temperature T_{BC}, and the temperature T_{BD} were all detected at the time t_{B1}, and so on.

The computing device 12A trains the computational model 19A by adjusting the weights assigned to various nodes of the computational model 19A based on the data sets 202A-N. The weights are adjusted incrementally after analyzing each of the data sets 202A-N so that the computational model 19A more accurately assigns a given group of temperatures detected by the temperature sensors 18B-D to a temperature detected by the temperature sensor 18A. In one example, the computational model 19A is a polynomial regression algorithm. Thus, the computing device 12A can adjust parameters of the following equation to reach an improved or optimal fit for the data sets 202A-N: *T_{A}* = *a + b*₁(*T_{B}*) *+ b*₂(*T_{C}*) *+ b*₃(*T_{D}*) *+ c*₁(*T_{B}*)² *+ c*₂(*T_{C}*)² *+ C*₃(*T_{D}*)². . .*+n*₁(*T_{B}*)*ⁿ* + *n*₂(*T_{C}*)*ⁿ + n*₃(*T_{D}*)*ⁿ.* Thus, the trained computational model 19A is configured to receive temperatures detected by the temperature sensors 18B-D during runtime operation of the power supply 14B as input, and generate or infer a temperature of the battery 16B without the use of a temperature sensor that directly monitors the battery 16B. This is done by training the computational model 19B to map the temperature T_{AB}, the temperature T_{AC}, and the temperature T_{AD} as a group to the temperature T_{AA}, to map the temperature T_{BB}, the temperature T_{BC}, and the temperature T_{BD} as a group to the temperature T_{BA}, and so on.

The data set 204A includes data collected at a time t_{A2}, the data set 204B includes data collected at a time t_{B2}, and the data set 204N includes data collected at a time t_{N2}, and so on. The data set 204A includes a voltage V_{A} of the battery 16A, a current I_{A} of the battery 16A, a charge state Q_{A} of the battery 16A, and a temperature T_{A} detected by the temperature sensor 18A. The data sets 204A-N each indicate the time period during which their data was collected. The data set 204B includes a voltage V_{B} of the battery 16A, a current I_{B} of the battery 16A, a charge state Q_{B} of the battery 16A, and a temperature T_{B} detected by the temperature sensor 18A. The data set 204N includes a voltage V_{N} of the battery 16A, a current I_{N} of the battery 16A, a charge state Q_{N} of the battery 16A, and a temperature T_{N} detected by the temperature sensor 18A. The voltages V could be numerical values in units of volts, the currents I could be positive or negative numerical values in units of amps, the charge states Q could be percentages or numerical values in units of amp-hours, and the temperatures could be numerical values in Celsius or Fahrenheit units, for example. By convention, the currents I would be positive when the battery 16A is providing power to a load and negative when being charged. The data sets 204A-N generally include data collected during various operational states of the power supply 14A, such as the power supply 14A operating with the normal mode bypass circuit 20A enabled, the power supply 14A operating with the battery mode bypass circuit 20B enabled, or the power supply 14A operating with the battery charger circuit 20C enabled. During training of the computational model 19B, the charge states Q of the battery 16A can be determined using any known method.

To train the computational model 19B, the computing device 12A accesses the data sets 204A-N that include the voltage V_{A}, the voltage V_{B}, the voltage V_{N}, the current I_{A}, the current I_{B}, the current I_{N}, the charge state Q_{A}, the charge state Q_{B}, the charge state Q_{C}, the temperature T_{A}, the temperature T_{B}, and the temperature T_{N}. As noted above, in some examples, the data sets 204A-N can include thousands of sets of data collected by the temperature sensors 18A-D, ammeters, or voltmeters during experiments.

The computing device 12A trains the computational model 19B by adjusting the weights assigned to various nodes of the computational model 19B based on the data sets 204A-N. The weights are adjusted incrementally after analyzing each of the data sets 204A-N so that the computational model 19B more accurately assigns a given set of a battery voltage, a battery current, and a battery temperature to a charge state. In one example, the computational model 19B is a polynomial regression algorithm. Thus, the computing device 12A can adjust parameters of the following equation to reach an improved or optimal fit with the data sets 204A-N: Q *= a + b*₁(*T*) *+ b*₂(*I*) *+ b*₃(*V*) *+ c*₁(*T*)² *+ c*₂(*I*)² + *c*₃(*V*)². . .+*n*₁(*T*)*ⁿ* + *n*₂(*I*)*ⁿ* + *n*₃(*V*)*ⁿ.* Thus, the trained computational model 19B is configured to receive, as input, a voltage V of the battery 16B detected via a voltmeter, a current I of the battery 16B detected by an ammeter, and a temperature T of the battery 16B inferred by the computational model 19A during runtime operation of the power supply 14B, and generate or infer a charge state Q of the battery 16B without the use of a temperature sensor that directly monitors the battery 16B. This is done by training the computational model 19B to map the battery voltage V_{A}, the battery current I_{A}, and the temperature T_{A} as a group to the charge state Q_{A}, to map the battery voltage V_{B}, the battery current I_{B}, and the temperature T_{B} as a group to the charge state Q_{B}, and so on.

Thus, during runtime operation, the computing device 12B receives the respective temperatures detected by the temperature sensor 18B, the temperature sensor 18C, and the temperature sensor 18D as input, and generates or infers the temperature of the battery 16B as output using the computational model 19A. The output can be generated by the user interface 116 and/or be stored on the computer readable medium 112. This process can be repeated periodically and/or continuously.

Next, the computing device 12B receives, as input, the voltage V across the battery 16B detected by a voltmeter, the current I flowing through the battery 16B detected by an ammeter, and the temperature T generated as output by the computational model 19A, and generates or infers the charge state Q of the battery 16B based on the voltage V, the current I, and the temperature T. The output can be generated by the user interface 116 and/or be stored on the computer readable medium 112.

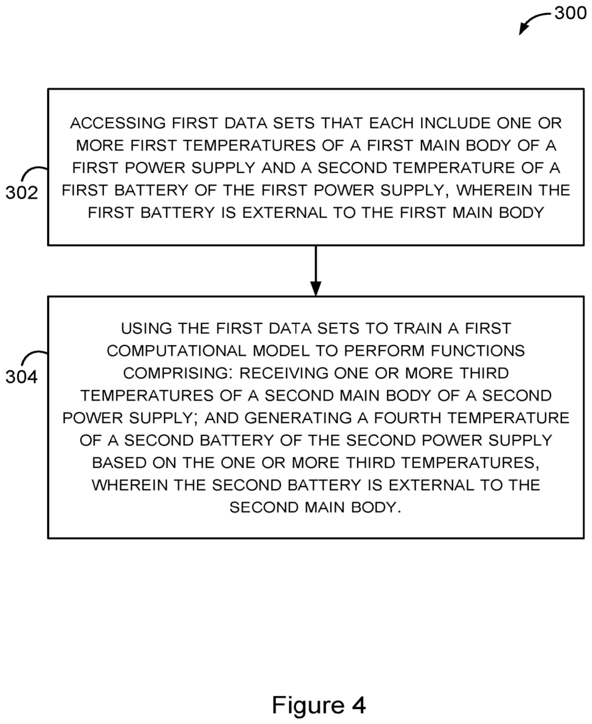

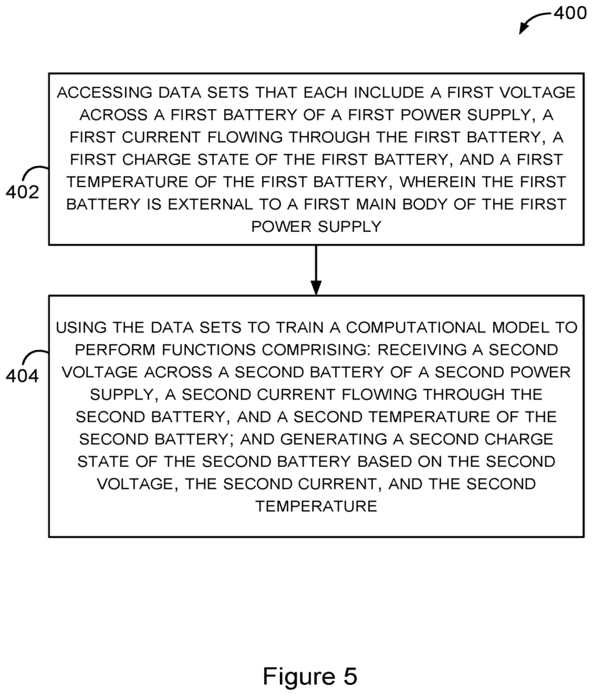

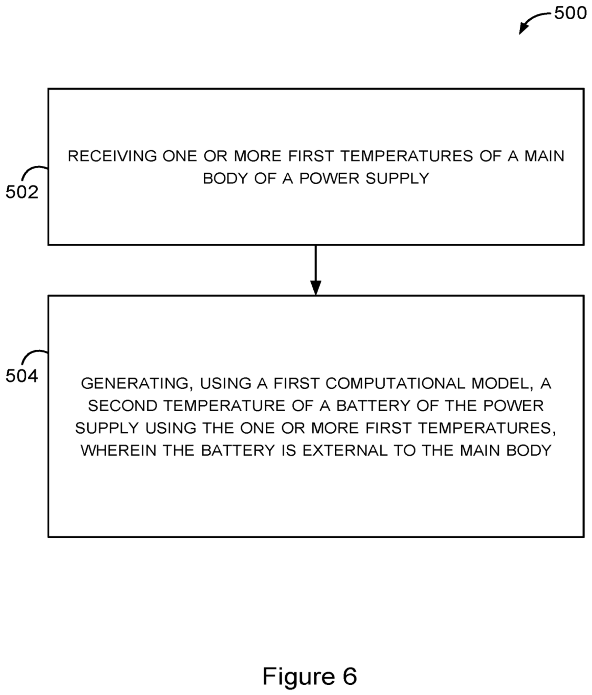

Figure 4, Figure 5, and Figure 6 are block diagrams of a method 300, a method 400, and a method 500, respectively, which in some examples are performed by the computing device 12A and/or the computing device 12B. As shown in Figures 4-6, the method 300, the method 400, and the method 500 include one or more operations, functions, or actions as illustrated by blocks 302, 304, 304, 402, 404, 502, and 504. Although the blocks are illustrated in a sequential order, these blocks may also be performed in parallel, and/or in a different order than those described herein. Also, the various blocks may be combined into fewer blocks, divided into additional blocks, and/or removed based upon the desired implementation.

At block 302, the method 300 includes the computing device 12A accessing the data sets 202A-N that each include the temperatures T of the main body 13A of the power supply 14A detected by the temperature sensors 18B-D and that each include the temperature of the battery 16A detected by the temperature sensor 18A. The battery 16A is external to the main body 13A. Functionality related to block 302 is described above with reference to Figures 1-3.

At block 304, the method 300 includes the computing device 12A using the data sets 202AN to train the computational model 19A to perform functions. The functions include receiving temperatures T of the main body 13B of the power supply 14B detected by the temperature sensors 18B-D, and generating or inferring a temperature of the battery 16B of the power supply 14B based on the temperatures T detected by the temperature sensors 18B-D. The battery 16B is external to the main body 13B. Functionality related to block 304 is described above with reference to Figures 1-3.

At block 402, the method 400 includes the computing device 12A accessing the data sets 204A-N that each include the voltage V across the battery 16A of the power supply 14A detected by a voltmeter, the current I flowing through the battery 16A detected by an ammeter, the (e.g., known) charge state Q of the battery 16A, and the temperature T of the battery 16A detected by the temperature sensor 18A. Functionality related to block 402 is described above with reference to Figures 1-3.

At block 404, the method 400 includes the computing device 12A using the data sets 204AN to train the computational model 19B to perform functions. The functions include receiving the voltage V across the battery 16B of the power supply 14B detected by a voltmeter, the current I flowing through the battery 16B detected by an ammeter, and the temperature T of the battery 16B generated or inferred by the computational model 19A. The functions further include generating or inferring the charge state Q of the battery 16B based on the voltage V across the battery 16B, the current I flowing through the battery 16B, and the temperature T of the battery 16B generated or inferred by the computational model 19A. Functionality related to block 404 is described above with reference to Figures 1-3.

At block 502, the method 500 includes the computing device 12B receiving the temperature T detected by the temperature sensor 18B of the power supply 14B, the temperature T detected by the temperature sensor 18C of the power supply 14B, and the temperature T detected by the temperature sensor 18D of the power supply 14B. Functionality related to block 502 is described above with reference to Figures 1-3.

At block 504, the method 500 includes the computing device 12B generating or inferring, using the computational model 19A, the temperature T of the battery 16B of the power supply 14B using the temperature T detected by the temperature sensor 18B of the power supply 14B, the temperature T detected by the temperature sensor 18C of the power supply 14B, and the temperature T detected by the temperature sensor 18D of the power supply 14B. Functionality related to block 502 is described above with reference to Figures 1-3.

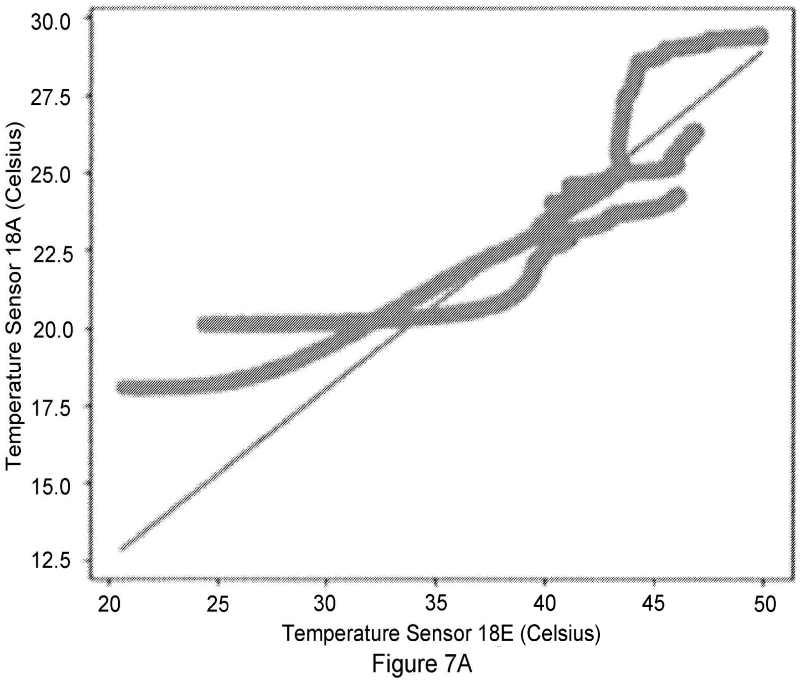

Figure 7A shows a correlation between temperatures detected by the temperature sensor 18E of the power supply 14A and temperatures detected by the temperature sensor 18A of the battery 16A.

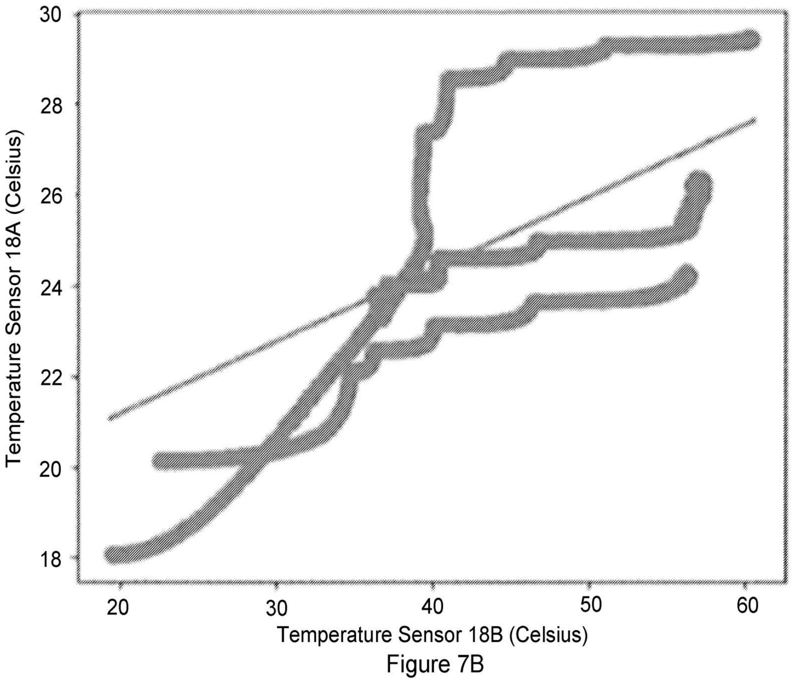

Figure 7B shows a correlation between temperatures detected by the temperature sensor 18B of the power supply 14A and temperatures detected by the temperature sensor 18A of the battery 16A.

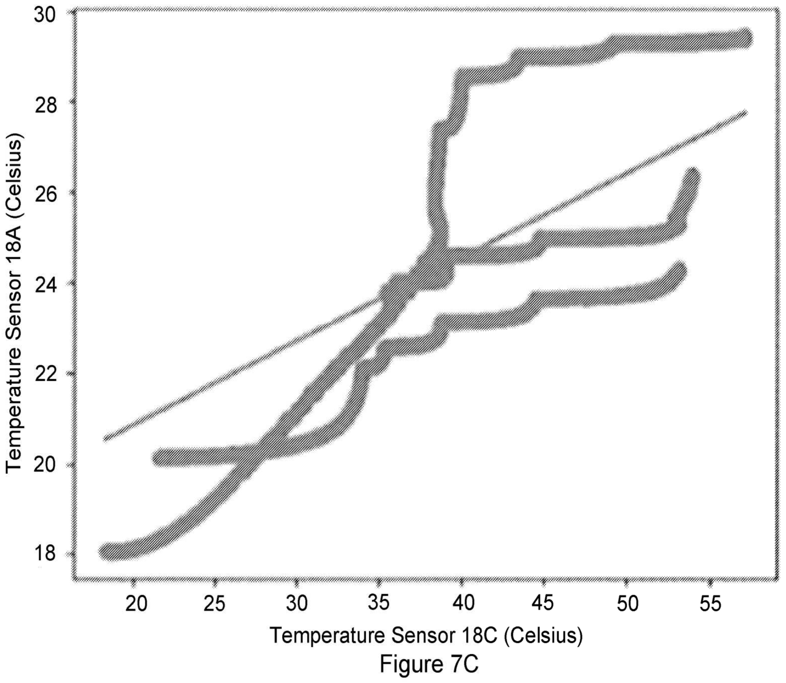

Figure 7C shows a correlation between temperatures detected by the temperature sensor 18C of the power supply 14A and temperatures detected by the temperature sensor 18A of the battery 16A.

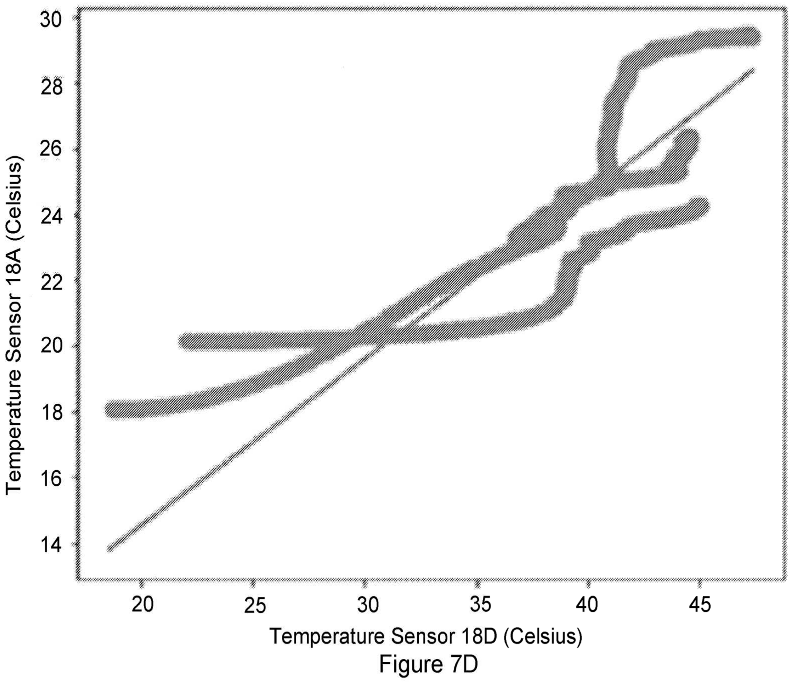

Figure 7D shows a correlation between temperatures detected by the temperature sensor 1DE of the power supply 14A and temperatures detected by the temperature sensor 18A of the battery 16A.

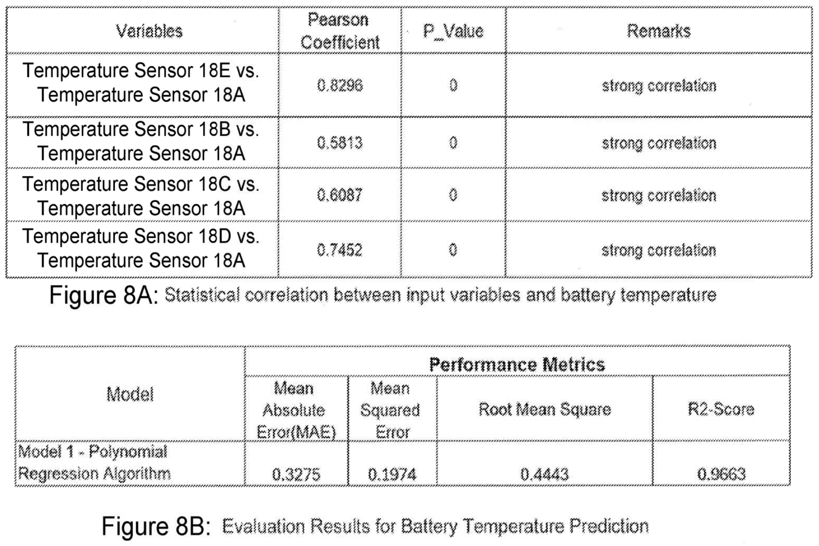

Figure 8A shows correlations between temperatures detected at various locations within the main body 13A of the power supply 14A and temperatures detected at the battery 16A.

Figure 8B shows correlations between temperatures detected at various locations within the main body 13A of the power supply 14A and temperatures detected at the battery 16A.

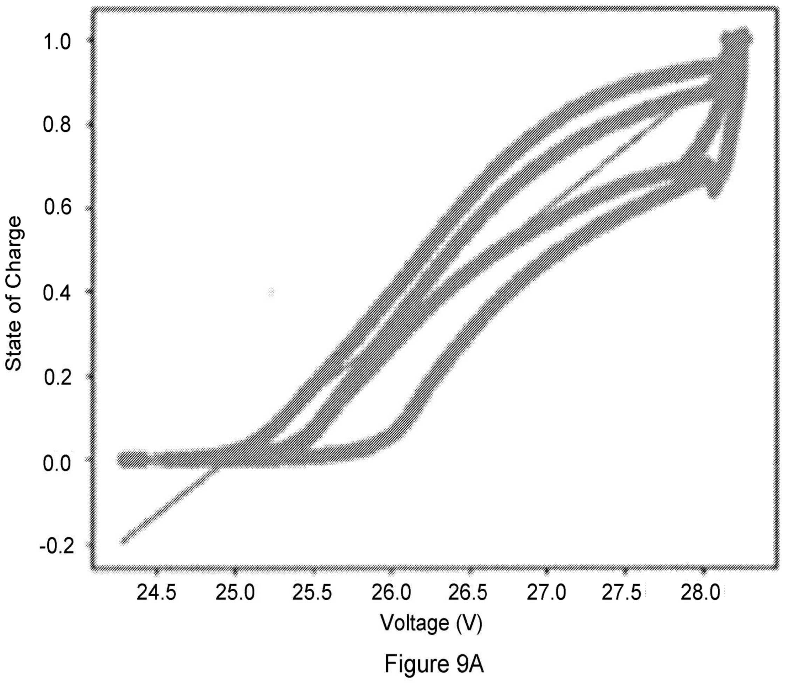

Figure 9A shows correlations between voltages of the battery 16A and states of charge of the battery 16A.

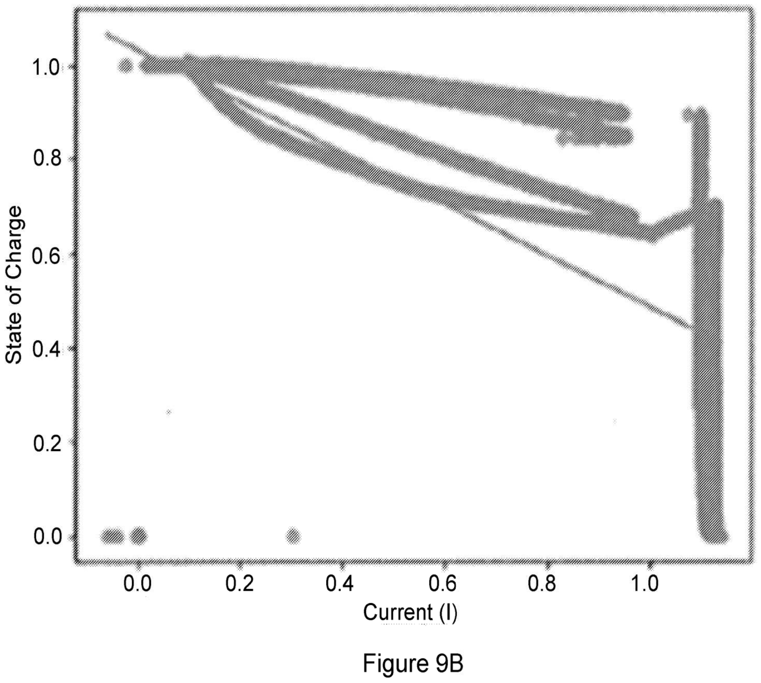

Figure 9B shows correlations between currents of the battery 16A and states of charge of the battery 16A.

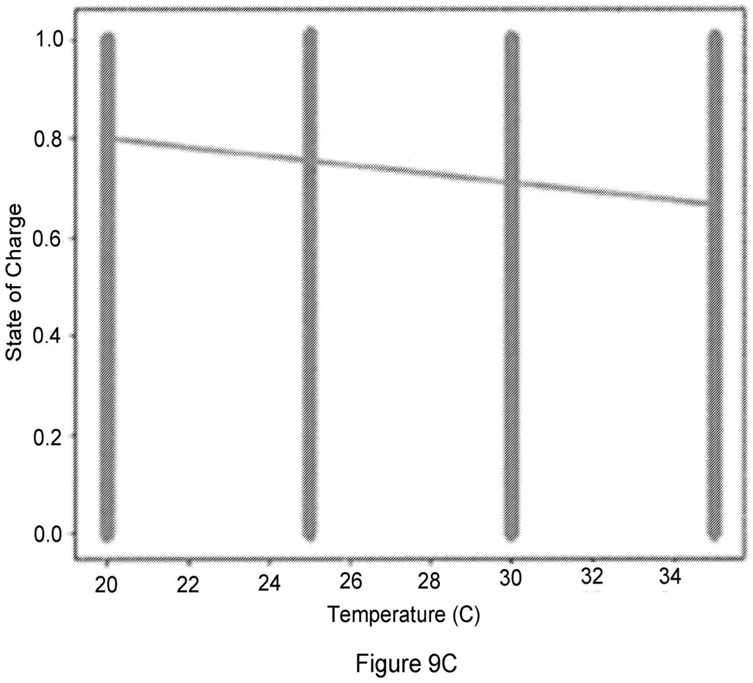

Figure 9C shows correlations between temperatures of the battery 16A and states of charge of battery 16A.

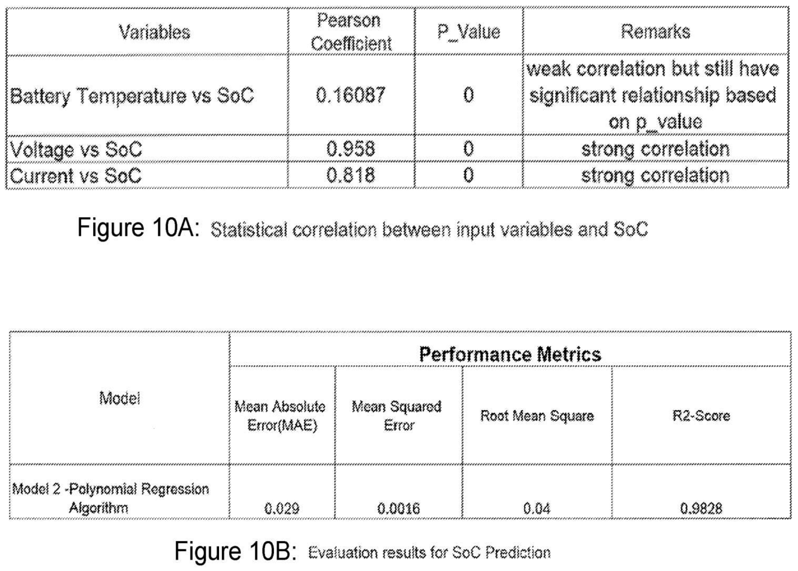

Figure 10A shows correlations between voltages, currents, and temperatures of the battery 16A, and states of charge of the battery 16A.

Figure 10B shows correlations between voltages, currents, and temperatures of the battery 16A, and states of charge of the battery 16A.

The description of the different advantageous arrangements has been presented for purposes of illustration and description, and is not intended to be exhaustive or limited to the examples in the form disclosed. Many modifications and variations will be apparent to those of ordinary skill in the art. Further, different advantageous examples may describe different advantages as compared to other advantageous examples. The example or examples selected are chosen and described in order to explain the principles of the examples, the practical application, and to enable others of ordinary skill in the art to understand the disclosure for various examples with various modifications as are suited to the particular use contemplated.

## Claims

1. A method comprising:
receiving one or more first temperatures of a main body of a power supply, wherein the one or more first temperatures comprise a temperature of a normal mode bypass circuit that is configured to receive a main power input and generate a first power output for a load, a temperature of a battery mode bypass circuit that is configured to receive an auxiliary power input from a battery and generate a second power output for a load, or a temperature of a charger circuit that is configured to charge the battery; and
generating, using a first computational model, a second temperature of the battery of the power supply using the one or more first temperatures, wherein the battery is external to the main body.

2. The method of claim 1, wherein the main body comprises a control module of the power supply.

3. The method of claim 2, wherein the one or more first temperatures are detected within the control module.

4. The method of claim 1, wherein the one or more first temperatures comprise a temperature of an interior surface of a housing of the main body.

5. The method of claim 1, wherein the one or more first temperatures comprise the temperature of the normal mode bypass circuit that is configured to receive the main power input and generate the first power output.

6. The method of claim 1, wherein the one or more first temperatures comprise the temperature of the battery mode bypass circuit that is configured to receive the auxiliary power input from the battery and generate the second power output.

7. The method of claim 1, wherein the one or more first temperatures comprise the temperature of the charger circuit that is configured to charge the battery.

8. The method of claim 1, wherein the battery is connected to the main body via a power cable.

9. The method of claim 1, wherein the first computational model is trained using a polynomial regression algorithm.

10. The method of claim 1, further comprising:
receiving a voltage across the battery, a current flowing through the battery, and the second temperature; and
generating, using a second computational model, a charge state of the battery based on the voltage, the current, and the second temperature.

11. The method of claim 10, wherein the second computational model is trained as a polynomial regression algorithm.

12. A non-transitory computer readable medium storing instructions that, when executed by a computing device, cause the computing device to perform the method of any one of claims 1-11.

13. A computing device comprising:
one or more processors; and
a computer readable medium storing instructions that, when executed by the one or more processors, cause the computing device to perform the method of any one of claims 1-11.
